# EUROPEAN PATENT APPLICATION

(11) **EP 4 757 536 A1**
(43) Date of publication of application: **10.06.2026**
(21) Application number: 25220445.8
(22) Date of filing: 03.12.2025
(51) Int. Cl.: H10D 89/60

(54) **AN ELECTROSTATIC DISCHARGE, ESD, PROTECTION DEVICE AND CORRESPONDING ASSEMBLY, ELECTRONIC DEVICE AND METHOD**

(30) Priority: 03.12.2024 NL 2039233
(71) Applicant: Nexperia B.V., 6534 AB Nijmegen (NL)
(72) Inventor: Ritter, Hans-Martin, Hamburg (DE); Zimmermann, Andreas, Hamburg (DE)
(74) Representative: Pjanovic, Ilija

(57) **Abstract**

An ElectroStatic Discharge, ESD, protection device for protecting an integrated circuit, said ESD protection device comprising a two-stage protection circuit arranged to be connected to an input of the integrated circuit, wherein the two-stage protection circuit comprises a first protection stage connected to an external input and to ground, wherein the first protection stage is arranged for, when triggered, providing a low ohmic path to said ground, an impedance connected to the external input and arranged to be connected to the input of the integrated circuit, a second protection stage arranged to be connected to the input of the integrated circuit and connected to ground, wherein the second protection stage is arranged for, when triggered, providing a low ohmic path to said ground, a triggering mechanism arranged for triggering the second protection stage with the first protection stage.

## Description

### TECHNICAL FIELD

The present disclosure relates to an ElectroStatic Discharge, ESD, protection device arranged to provide ESD protection through two protection stages.

### BACKGROUND OF THE DISCLOSURE

Electrostatic Discharge, ESD, is a sudden flow of electricity between two objects with different electric potentials. ESD may be caused by contact or a short circuit. This phenomenon occurs when static electricity builds up on an object and then finds a pathway to discharge, typically through another conductive material. ESD is a common issue in electronics because electronic components are sensitive to sudden voltage spikes, which can damage circuits such as integrated chips, ICs. This may degrade the performance of these circuits or may even cause complete failure. ESD can result from everyday actions, such as walking across a carpeted floor or wearing certain clothing, creating the need for ESD protection.

One such ESD protection comprises a two-stage ESD protection device. Two-stage ESD protection is a method used in electronic circuits to neutralize potentially damaging electrostatic distances. The two-stage ESD protection device comprises, as the name suggests, two stages and a resistive element. A first stage of protection may comprise a first protection structure, which drains most of the external stress of the ESD event to ground. A second stage is provided in parallel with the first stage. The second stage is connected to the first stage via the resistive element. The second stage may handle any residual energy passing the first protection layer.

One of the parameters that may be of importance for the second stage are the maximal voltage and the maximal current on the input of the IC. The voltage reaching the IC must not exceed this voltage, as it may otherwise be damaged or destroyed. Further, the current reaching the IC should be as low as possible, this is because a high current may cause significant damage.

The second stage is in parallel with the IC. By conducting as much current as possible during an ESD event, this stage serves as a diversion pathway, which ensures that the majority of the power of the ESD event is redirected away from the IC.

The combined current through the second stage and the IC causes a voltage drop in the resistive element. Therefore, the clamping voltage of the first stage can be higher than the maximal voltage on the input of the IC. Without the second stage, the current through the resistor would be much smaller (maximal current on the IC being the allowable limit) and the voltage drop would be smaller. In that case the clamping voltage of the first stage would have to be much smaller. This means the possible current through the first stage would be smaller. This means, the overall protection robustness would be smaller. In that way, the second stage improves the system robustness.

### Summary

First and second stage may be snap-back devices. Such devices typically have a trigger voltage that must be exceeded to switch the device from its high ohmic to its low ohmic state.

Triggering the second stage of the ESD protection circuit may be problematic, as this may rely on the magnitude of the voltage. This is typically low, as the maximal voltage on the input of the IC should be low

Triggering the first stage is much easier because the allowable voltage at that location is much higher than the maximal voltage of the IC. Therefore, it may be beneficial if a triggering system within the ESD protection circuit is achieved, which couples the triggering of the second protection stage with the triggering of the first protection stage. This ensures that the triggering of the second stage does not depend on the voltage provided at the input of the IC that should never exceed a predetermined voltage.

In a first aspect of the disclosure, there is provided an ElectroStatic Discharge, ESD, protection device for protecting an integrated circuit, said ESD protection device comprising:
- a two-stage protection circuit arranged to be connected to an input of the integrated circuit, wherein the two-stage protection circuit comprises:
   - a first protection stage connected to an external input and to ground, wherein the first protection stage is arranged for, when triggered, providing a low ohmic path to said ground;
   - an impedance connected to the external input and arranged to be connected to the input of the integrated circuit;
   - a second protection stage arranged to be connected to the input of the integrated circuit and connected to ground, wherein the second protection stage is arranged for, when triggered, providing a low ohmic path to said ground;
   - a triggering mechanism arranged for triggering the second protection stage with the first protection stage.

The inventors have found that in order to protect an integrated circuit from an electrostatic discharge, ESD, event, an ESD protection device may be provided before the integrated circuit, IC, in between an external input and the input of the IC. During an ESD event, voltages can range from 500 volts up to 15000 volts or more. The current may also spike, ranging from a few amperes to tens of amperes.

The inventors have found that a triggering mechanism may be provided in order to trigger the two-stage protection stage, namely triggering the second protection stage with the first protection stage. This is of importance as, as mentioned before, the voltages of the second protection stage may be insufficient for the reliable triggering of that protection stage

First, the first protection stage is arranged to drain most of the external stress, being the ESD event, to ground via the provided low-ohmic path. This drains a first part of the current of the ESD event. The first protection stage is therefore provided in parallel with the connection line from the external input to the input of the IC. The first protection stage clamps the voltage to a level depending on the current through the first stage. The remaining part of the ESD current flows through the resistor to the IC and to the second stage. This current causes a voltage drop proportional to the resistance value of and the current through the resistor. Therefore, the voltage behind the resistor, that is seen by the IC and the second stage, is smaller than the clamping voltage of the first stage, ideally smaller than the maximal voltage on the input of the IC..

This leaves the second protection stage. In order to trigger a protection stage, the voltage applied to the protection stage should typically be high. To activate a protection stage, the voltage across the protection stage must exceed the threshold of the protection stage. This high voltage, triggers the protection stage, forcing the protection stage into its low ohmic mode so that it conducts a current away from the IC. However, due to the maximal operating voltage of the IC, the voltage is low at the second protection stage, meaning that the second protection stage may not be triggered.

Therefore, the triggering mechanism is arranged for triggering this second protection stage with the first protection stage. This ensures that the second protection stage provides the low ohmic path to ground, thereby conducting current away from the sensitive IC, protecting it from harmful currents of the ESD event.

In an example of the disclosure, said triggering mechanism is arranged for triggering both said first and said second protection stage.

The inventors have found that by triggering the first protection stage and triggering the second protection stage by the triggering mechanism, the switching on of the protection stages may be better controlled. This means that a threshold voltage does not have to be exceeded in the protection stages themselves, but a separate sensing component may sense the voltage and/or current and is able to enable the protection stages. This sensing component is placed before the impedance, ensuring that the ESD will not reach the second protection stage before it has been triggered. Thereby switching the first protection stage together with the second protection stage. This triggering mechanism ensures that the second protection mechanism is triggered, protecting the IC from harm.

In an example of the disclosure, said triggering mechanism is arranged for triggering said second protection stage when said first protection stage has been triggered.

The inventors have found that the second protection stage may also be triggered after triggering of the first protection stage. Herein the first protection stage may provide a signal to the second protection stage, which may be through a sensing component, which monitors the first protection stage, or it may provide a direct signal to the second protection stage. In either case, the signal is used to trigger the second protection stage. Thereby, the second protection stage is triggered with the first protection stage. Herein the first protection stage is used for triggering the second protection circuit. This again causes the second protection stage to provide a low ohmic path to ground thereby protecting the IC from harmful currents.

In an example of the disclosure, said triggering mechanism is driven by an input voltage at said external input exceeding a predefined voltage threshold.

The inventors have found that by utilizing a triggering mechanism, which is triggered when an input voltage at said external input exceeds the predefined voltage threshold, it allows the triggering mechanism to trigger the second protection stage or the second and first protection stages. This may, for example, be done using a antiserial diode or any other device which may trigger at a certain predefined threshold. This may therefore, for example, comprise an open transistor, which triggers anyway at a threshold voltage. The triggering mechanism is connected to the external input and in parallel with the first and second protection stages. Notably it is connected before the impedance, as this allows the triggering mechanism to trigger due to the input voltage at the external input.

In an example of the disclosure, said first protection stage is triggered by an input voltage at said external input exceeding a predefined voltage threshold.

In order to trigger the first protection stage, either the above-mentioned switching/triggering mechanism may be used, or the predefined voltage threshold should be exceeded. This may cause the first protection stage to conduct current.

While in principle this same concept may be used for the second protection stage, the maximal voltages of the IC are typically lower or at least close to the threshold voltage of the second protection stage. This results in the switching on of the second protection stage being unreliable. Therefore, the second protection stage is triggered with the first protection stage.

Therefore, this concept primarily applies to the triggering of the first protection stage. This also allows the first protection stage to trigger the second protection stage, thereby triggering the second protection stage with the first protection stage. The switching of the first protection stage can namely be used in switching the second protection stage, either directly or indirectly.

In an example of the disclosure, the triggering mechanism comprises a snap-back device.

The inventors have found that a snap-back device may be used in a protection stage. A snap-back device is a type of protective circuit that may be used in protecting against ESD events. This is because a snap-back device incorporates a mechanism that triggers when a threshold voltage is exceeded, which is prevalent in ESD events, responding by quickly diverting excess current, thereby protecting the sensitive IC from damage.

A thyristor is a semiconductor device that acts as a switch. In the technical area of ESD protection, the thyristor is also known as SCR (silicon controlled rectifier). It consists of four layers of alternating P and N-type materials. The thyristor remains off until a small current is applied to the gate terminal, allowing a larger current to flow between the anode and cathode. This basically triggers the gate to provide a conductive state to the thyristor. The thyristor may be turned off by reducing the current below a certain level. Therefore, if the ESD event is over, the thyristor may turn off, preventing the further diversion of now intentionally applied current.

Further, the thyristor may switch on when a high voltage is applied. If the voltage exceeds a breakdown voltage, it may clamp the voltage, allowing the thyristor to conduct current from the ESD event away from sensitive components such as the IC.

In an example of the disclosure, the triggering mechanism comprises a current source, wherein the current source triggers at least the second protection stage.

In an example of the disclosure, the first protection stage and/or the second protection stage comprises any of:
- a Transistor.
- a silicon controlled rectifier, SCR.

The inventors have found that the first and/or second protection stage may comprise a transistor and/or a SCR. This transistor and or SCR may be provided as it may be triggered, either by the triggering mechanism, or by the clamping of the voltage at high voltages. Transistors and or SCR are therefore useful devices in the two-stage protection circuit, as it allows the switching on and off of either of the first protection stage and the second protection stage.

In an example of the disclosure, the second protection stage comprises the transistor or SCR, and wherein the triggering mechanism is arranged to trigger the transistor ad or SCR by controlling the control terminal of the transistor or SCR.

The triggering mechanism may trigger the transistor or SCR by controlling the control terminal. The control terminal of a transistor or SCR is a component of the transistor or SCR regulates the flow of electrical current between two other terminals. By applying a voltage or signal to this control terminal, the transistor or SCR can turn on or off, enabling or blocking current flow, and thus functioning as a switch or amplifier.

Herein the triggering mechanism may be arranged to provide a voltage exceeding the threshold voltage to the control terminal of the transistor or SCR, thereby switching the transistor or SCR to conductive mode and providing said low ohmic path to ground. This may be beneficial as this may provide a simple arrangement to trigger the second protection stage.

In an example of the disclosure, the transistor and/or the SCR is any of:
- A Field Effect Transistor, FET;
- A Bipolar Junction Transistor, BJT;
- a Thyristor.

The above-mentioned transistor comprising its control terminal may be any of these transistors, and even other transistors such as IGBTs and HEMTs, such as GaN HEMTs, which have improved switching capabilities.

In a MOSFET, the control terminal, known as the gate, uses voltage to create an electric field that modulates conductivity between the source and drain terminals. By applying a positive or negative voltage to the gate, the MOSFET can switch on or off, effectively controlling current flow.

The control terminal of a BJT is called the base. By injecting a small current into the base terminal, the transistor allows a larger current to flow between the collector and emitter. This current amplification enables the BJT to function as a switch.

In a thyristor, when a small current is applied to the gate, it triggers the device to conduct current between the anode and cathode. Once turned on, the thyristor remains in a conducting state until the current drops below a certain threshold.

In an example of the disclosure, the first and second protection stage comprise:
- a transistor or SCR implemented as a multi finger structure in a semiconductor material, wherein an active finger of said multi finger structure triggers an inactive finger of said multi finger structure.

The inventors have found that sequential finger triggering may be used as a triggering mechanism to trigger the second stage. Herein the first protection stage and second protection stage, which are in this example incorporated in a multi finger structure. When an ESD event occurs, the first protection stage experiences an increased current and voltage. This may be first applied to the first finger, which may trigger the following fingers of the multi finger structure or the fingers of the first protection stage may trigger simultaneously or substantially simultaneously due to the high voltages applied.

Due to the configuration and working of the multi finger structure, following fingers, for example of the second protection stage, are also triggered. This happens as follows:the surroundings of an active finger is altered by strong carrier injection, especially by injection of minority carriers. These excessive carriers may reach the neighbouring finger and drive that finger from the blocking mode to the conducting mode.

In an example of the disclosure fingers of said first protection stage comprises a first set of fingers and said second protection stage comprises a second set of fingers and said ground comprises a third set of fingers;
wherein the first set is interleaved with the third set and wherein the second set is interleaved with the third set of fingers.
wherein said active fingers of said first or second set are electrically connected to neighbouring fingers of said third set;
wherein an active finger of said first set is arranged to trigger an inactive finger of said second set.

The inventors have found that the fingers of the first and second set are interleaved with the fingers of the third set(ground). This results in a possible electrical connection between said finger of the first and/or second set and the finger of ground. Due to sequential finger triggering, the next finger of the first or second set is triggered through the connection of the previous active finger and the finger of ground. The triggering of an inactive finger of the second set is performed with an active finger of the first set. However, inactive fingers of the first set may, for example at an earlier stage, be triggered by active fingers of the first set. This is also true for the second set, wherein the inactive fingers of the second set may, for example at a later stage, be triggered by active fingers of the second set.
The first set of fingers that form the first stage are connected to the external connector, the second set of fingers that form the second stage are connected to the input of the IC, the third set of fingers is connected to ground.

One or more or all fingers of the first set of fingers may be triggered by an ESD stress at the external connector. By sequential finger triggering the active state of any active finger will trigger any non-active finger on its left or right side. Eventually all fingers will have been triggered and will be in their active state. This includes all fingers of the the second stage, too.

In an example of the disclosure, said second set of fingers is provided in extension of said first set of fingers;
wherein upon the triggering of an inactive finger of said first set of fingers, said finger of said second set in extension with said triggering finger of said first set is triggered. The inventors have found that said second set of fingers may be in extension with the first set of fingers. This means that each of the fingers of the second set is in extension with a respective finger of the first set. When the triggering of a further finger occurs, due to the high voltages applied, the second protection stage triggers along with it. This is due to the spreading of the current throughout a finger. The current does not only flow from the shortest distance from a terminal of the protection stage to ground, but the current may spread out over the whole finger. This causes the current to also encounter the second protection stage, from where the triggering of the fingers is further continued. For a visualisation of the multi finger structure, the figures may be consulted.

In a second aspect of the disclosure, there is provided an assembly of an ESD protection device in accordance with the disclosure and an integrated circuit,
wherein the two-stage protection circuit is connected to the input of the integrated circuit,
wherein the impedance is connected to the external input and to the input of the integrated circuit,
wherein the second protection stage is connected to the input of the integrated circuit and connected to ground.

In the assembly the ESD protection device is connected to the integrated circuit. This allows the ESD protection device to protect said integrated circuit. This follows that in order to provide the protection, the ESD protection device needs to be connected to the integrated circuit. This allows the first protection stage, at which a high voltage is present, to divert a portion of the current of an ESD event to ground, while the impedance causes the voltage to drop to safe operating ranged, below an allowed maximum voltage of the integrated circuit. Then, the second protection stage, triggered with the first protection stage, diverts excess current to ground protecting the integrated circuit from the leftover dangerous currents of the ESD event.

In a third aspect of the disclosure, there is provided an electronic device comprising an assembly in accordance with the disclosure.

The inventors have found that an electronic device may comprise an assembly with an Electrostatic Discharge, ESD, protection device and an integrated circuit to ensure the electronic device's durability in environments prone to electrostatic interference. The ESD protection device protects sensitive components within the integrated circuit by diverting harmful static charges away from the circuit, which is especially important in applications where even small electrostatic discharges could cause malfunctions.

In a fourth aspect of the disclosure, there is provided a method of providing ElectroStatic Discharge, ESD, protection by an ESD protection device in accordance with the disclosure, wherein said method comprises the steps of:
- triggering, by said triggering mechanism, said second protection stage with said first protection stage.

In an example of the disclosure, said step of triggering comprises one of:
- triggering both said first and said second protection stage, or
- triggering said second protection stage when said first protection stage has been triggered.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### BRIEF DESCRIPTION OF THE DRAWINGS

The disclosure will now be discussed with reference to the drawings, which show in:
Figure 1 depicts a first example of an ESD protection device in accordance with the disclosure, connected to an integrated circuit, IC;
Figure 2 depicts a second example of an ESD protection device in accordance with the disclosure, connected to an integrated circuit, IC;
Figure 3 depicts a third example of an ESD protection device in accordance with the disclosure, connected to an integrated circuit, IC;
Figure 4 depicts a fourth example of an ESD protection device in accordance with the disclosure, connected to an integrated circuit, IC;
Figure 5 depicts a fifth example of an ESD protection device in accordance with the disclosure, connected to an integrated circuit, IC;
Figure 6 depicts a sixth example of an ESD protection device in accordance with the disclosure, connected to an integrated circuit, IC;
Figure 7 depicts a seventh example of an ESD protection device in accordance with the disclosure, connected to an integrated circuit, IC;
Figure 8 depicts a multi finger structure in accordance with the disclosure;
Figure 9 depicts an eight example of an ESD protection device in accordance with the disclosure, connected to an integrated circuit, IC.
Figure 10 depicts a ninth example of an ESD protection device in accordance with the disclosure, connected to an integrated circuit, IC.
Figure 11 depicts a tenth example of an ESD protection device in accordance with the disclosure, connected to an integrated circuit, IC.

### DETAILED DESCRIPTION OF THE DISCLOSURE

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof.

Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

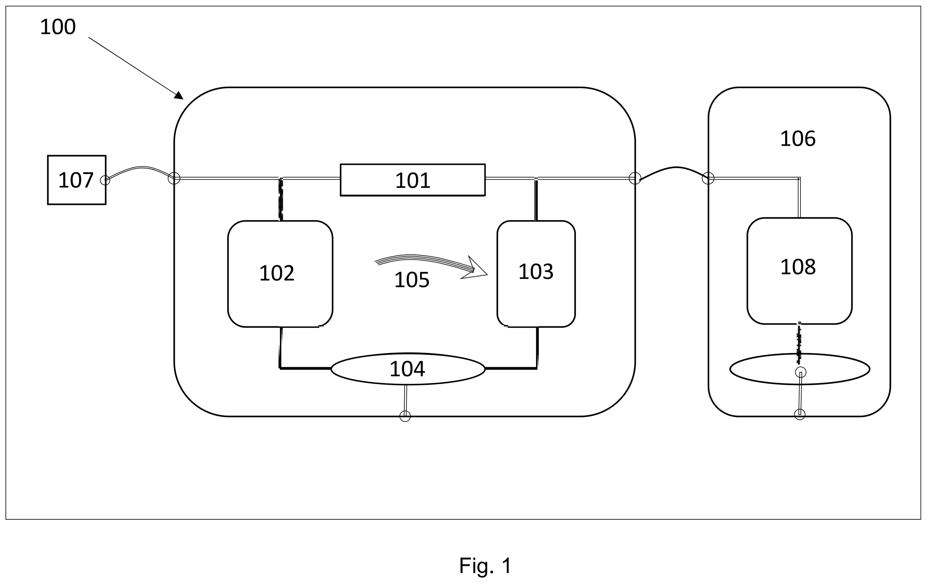

Figure 1 depicts a first example of an ESD protection device in accordance with the disclosure, connected to an integrated circuit, IC. Herein the ESD protection device 100 is connected to an external input 107 and an IC 106. The IC itself also comprises an internal protection circuit 108 for providing an additional protection layer 108.. Excess current that occurs at the input of the IC is drained to ground by this structure 108. Therefore, the IC also draws a certain amount of current.

The ESD protection device 100 comprises an impedance 101, which is arranged to provide a voltage drop over the ESD protection device 100, in order to conform to maximal operating voltages of the IC 106. The ESD protection device is further arranged to provide ESD protection during on ESD event. This is done by providing a first protection stage 102 and a second protection stage 103. The first protection stage 102 diverts part of the current, and thereby load, of the ESD event to ground 104 during an ESD event. This first protection stage may be triggered due to high voltages of the ESD event exceeding a threshold voltage. Further is provided the second protection stage 103, which is arranged to further divert current to ground 104. This protects the IC 106 from harm. The first protection stage 102 does not divert all current. Otherwise, the impedance 101, cannot lower the voltage to safe operating ranges, this namely depends on the resistance times the current running through it. This current is the sum of the current that is drained within the IC and the current through the second stage 103. Only if the second stage 103 is triggered, current will flow through the second stage. This stage 103 is triggered 105 with the first protection stage.

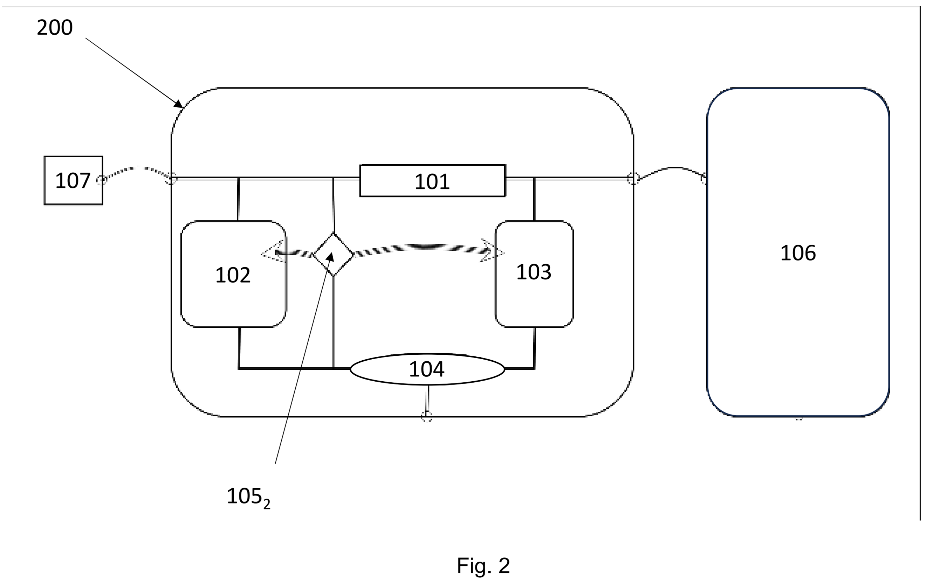

Figure 2 depicts a second example of an ESD protection device in accordance with the disclosure, connected to an integrated circuit, IC.

Herein, the ESD protection device is equipped with a trigger element 105₂, which is able to trigger the first and second protection stages 102,103 simultaneously. This allows the second protection stage 103 to be reliably triggered without relying on a voltage at the second protection stage 103, which is typically too low to reliably trigger this second protection stage 103.

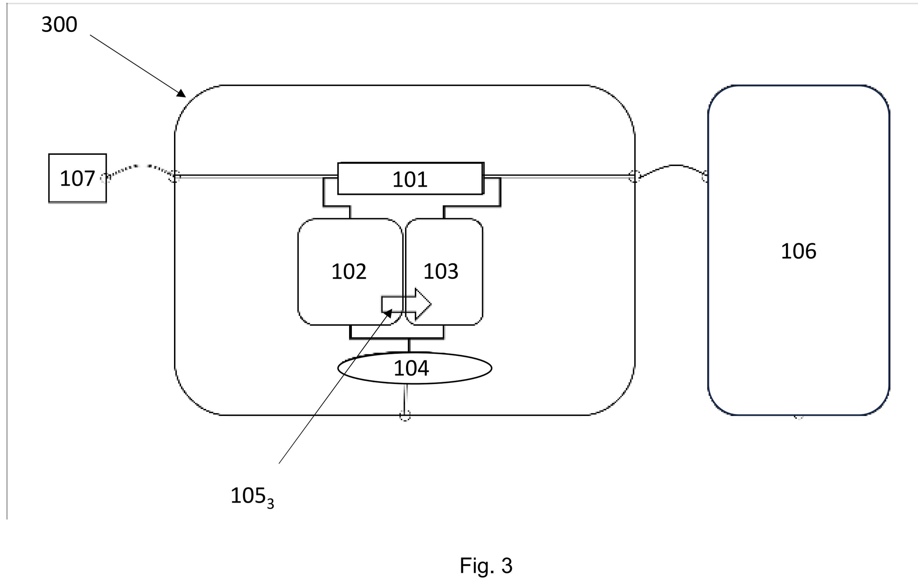

Figure 3 depicts a third example of an ESD protection device in accordance with the disclosure, connected to an integrated circuit, IC.

Herein, the first and the second protection stages 102, 103 are arranged such that upon triggering the first protection stage 102, the second protection stage 103 is triggered due to an internal triggering mechanism 105₃. This allows the triggering of the second protection stage 103 with the first protection stage 102.

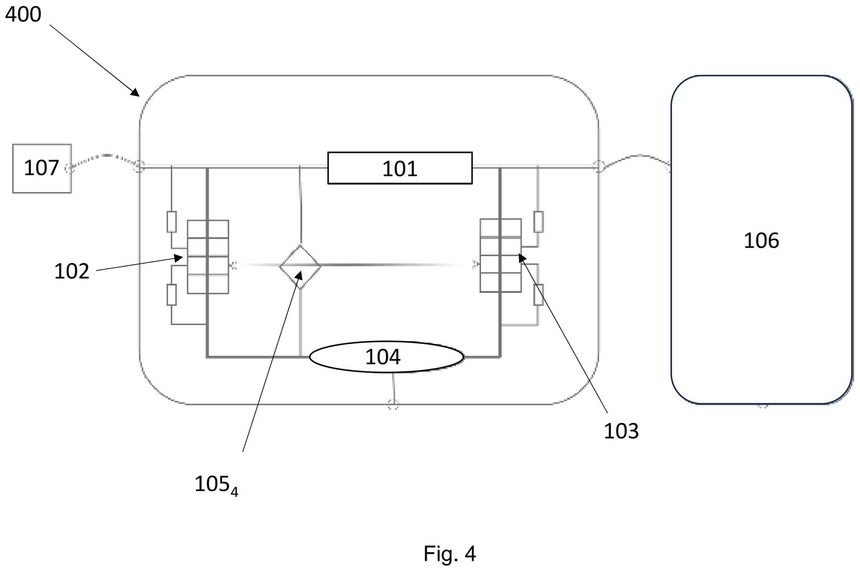

Figure 4 depicts a fourth example of an ESD protection device in accordance with the disclosure, connected to an integrated circuit, IC. This is an example for the general idea as described in Figure 2. Herein the first and the second protection stages 102, 103 each comprises a silicon-controlled rectifier, SCR, which may be a thyristor. An SCR thyristor has three terminals: anode, cathode, and gate. When a voltage is applied between the anode and cathode and a triggering pulse is applied to the gate, the SCR turns on, allowing current to pass from the anode to the cathode. Therefore, the thyristor may be triggered by a trigger 105₄. The trigger allows the thyristor to conduct current, thereby granting a low ohmic path and providing the desired ESD protection.

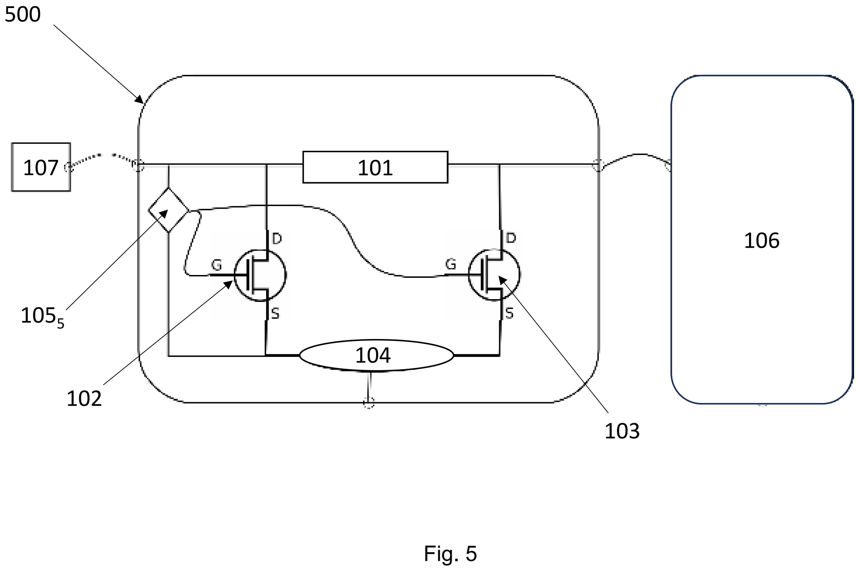

Figure 5 depicts a fifth example of an ESD protection device in accordance with the disclosure, connected to an integrated circuit, IC. This is a second example for the general idea as described in Figure 2.

In this example, the trigger 105₅ is connected to the first and second protection stages 102, 103 being transistors, which may be MOSFETs. The ESD protection device may also comprise a thyristor and a transistor, therefore, even though it is shown with two of the same components, mixing may be possible.

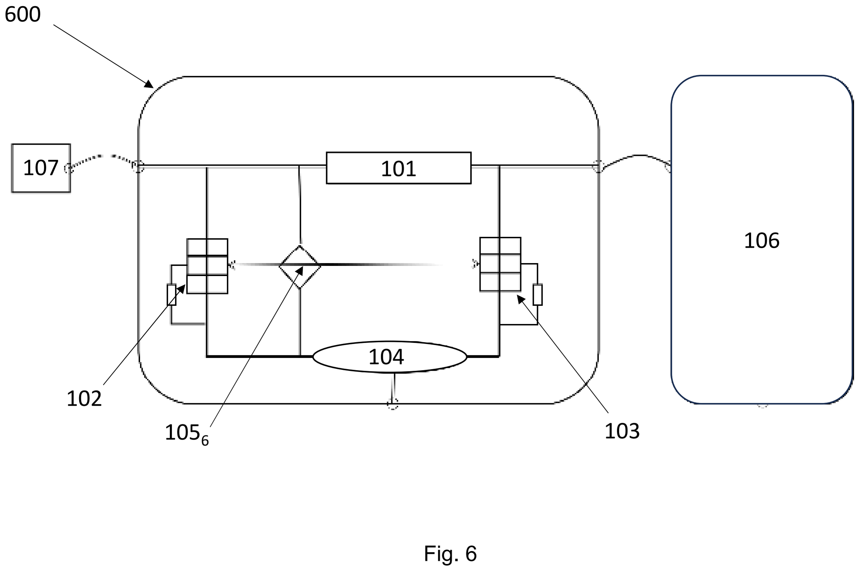

Figure 6 depicts a sixth example of an ESD protection device in accordance with the disclosure, connected to an integrated circuit, IC. This is a third example for the general idea as described in Figure 2.

In this example, the transistors are BJTs. This may again be triggered by a trigger, by applying a gate signal and putting the transistor into conductive mode.

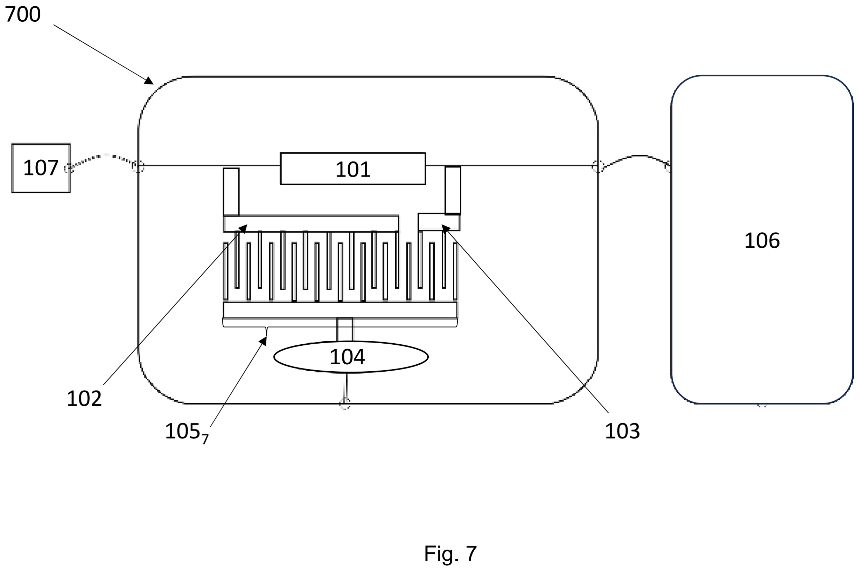

Figure 7 depicts a seventh example of an ESD protection device in accordance with the disclosure, connected to an integrated circuit, IC. This is a first example for the general idea as described in Figure 3.

In this example, the triggering mechanism comprises a multi finger structure 105₇. This structure acts as both the trigger and as the first and second protection stages 102, 103. As can be seen, the first protection stage 102 comprises fingers going down towards ground 104. Ground comprises fingers that run up toward both the first and second protection stages 102 103. The second protection stage 102 then also comprises fingers going down towards ground 104. In the multi finger structure, the first protection stage 102 and the second protection stage 103 are combined into one multi finger structure. One or more fingers are connected to the IC 106 via the connector 103, forming the second protection stage. All other fingers are connected to the external input 107 via the connector 102, forming the first protection stage. The first protection stage 102 is triggered by an ESD stress at the input 107. The fingers connected to the second stage will be triggered by sequential finger triggering". This effect occurs especially in SCRs, but also in other devices like e.g BJTs. If one finger has been triggered and has switched to its low ohmic state it will carry current. This current changes the surroundings of the active finger, e.g. by injecting large amounts of carriers into the surrounding substrate. These changes can reach the next finger and cause this finger to switch to the conducting mode as a consequence. The fingers connected to first protection stage 102 will be triggered by the ESD pulse (not shown here). Sequential finger triggering will trigger the fingers connected to second protection stage 103. This therefore allows the triggering of the second protection stage 103 with the first protection stage 102.

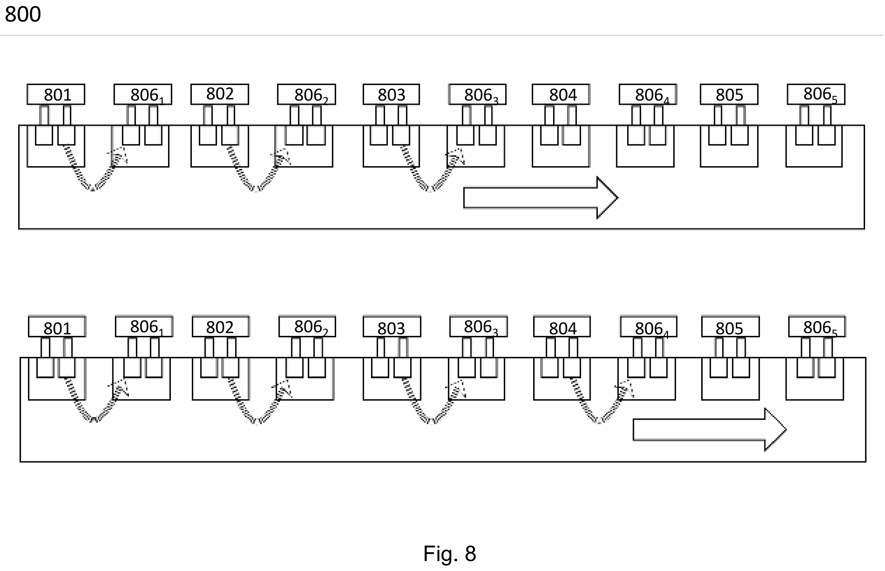

Figure 8 depicts a schematic cross section of multi finger structure in accordance with the disclosure.

Here, the sequential finger triggering is depicted more in detail. Here a first, second and third finger 801, 802 and 803 when a sufficient voltage is applied, are connected to ground fingers 806₁, 806₂ and 806₃. Due to the high current density and the presence of semiconductor material conforming the source terminal semiconductor material the current density is spread out over the semiconductor material, triggering finger 4 and allowing the formation of a current path from the fourth finger 804 to ground 806₄. This allows current to flow through 804 to ground 806₄, thereby locally increasing the current density which may spread out to the next finger 806₅. This current may trigger finger 805, creating a current path between ground 806₅ and the fifth finger 805. This process continues until all fingers are conducting, creating low ohmic paths.

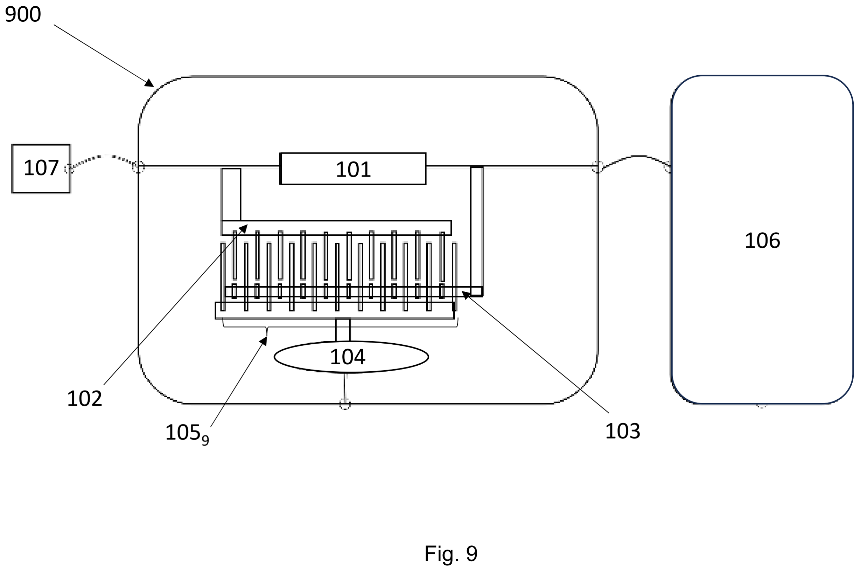

Figure 9 depicts an eight example of an ESD protection device in accordance with the disclosure, connected to an integrated circuit, IC.

This configuration uses the principle of current spreading. Herein, the current is spread out over the whole finger, thereby providing the trigger of the second protection stage 103 with the first protection stage 102. It follows the same principle of sequential finger triggering, though the fingers of the first and the second protection stages 102 103 are now aligned, allowing both protection stages to comprise more fingers.

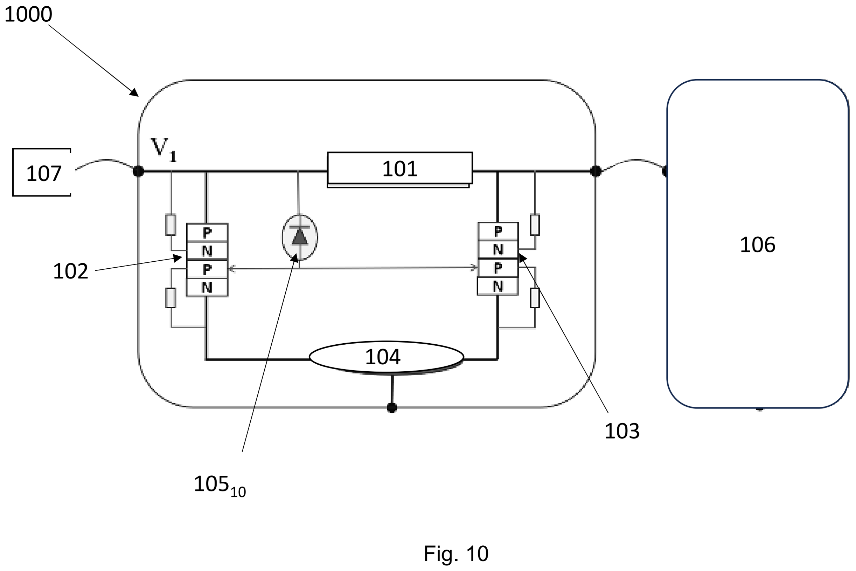

Figure 10 depicts a ninth example of an ESD protection device in accordance with the disclosure, connected to an integrated circuit, IC. This is a first example of the more general structure as described in Figure 4. Herein the trigger is formed as a diode placed between the input and the bases of the npn transistors that are part of the two SCRs of the first and the second protection stages 102, 103.

When the input voltage exceeds the breakdown voltage of the diode then current will flow through the diode and further through the base resistances of the two npn transistors. This current through the base resistors causes a voltage drop between the emitter and base, which eventually causes these junctions to be forward biased and causing the emitter-base current to increase. This starts the feedback loop that eventually triggers the SCRs and brings it into its low ohmic conducting state.

The diode in figure 10 might be replaced by any structure with a diode-like behaviour, as known by the person skilled in the art. This might include a transistor, either in open base configuration or with base and emitter shorted, a diode in forward mode, a MOS-diode, a Shockley diode or a stack of any of these structures.

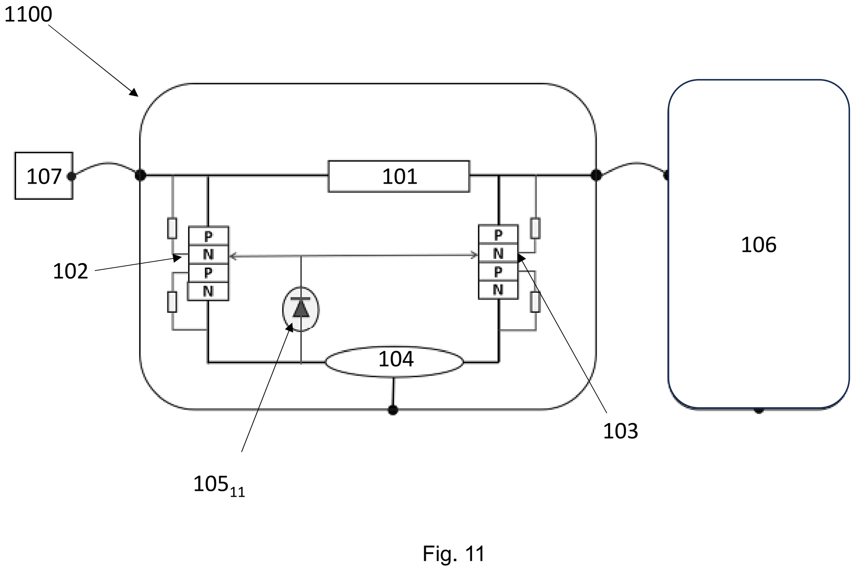

Figure 11 depicts a tenth example of an ESD protection device in accordance with the disclosure, connected to an integrated circuit, IC. This is another example of the placement of the diode as a trigger for the first and the second protection stages 102 103.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

## Claims

1. An ElectroStatic Discharge, ESD, protection device for protecting an integrated circuit, said ESD protection device comprising:
- a two-stage protection circuit arranged to be connected to an input of the integrated circuit, wherein the two-stage protection circuit comprises:
- a first protection stage connected to an external input and to ground, wherein the first protection stage is arranged for, when triggered, providing a low ohmic path to said ground;
- an impedance connected to the external input and arranged to be connected to the input of the integrated circuit;
- a second protection stage arranged to be connected to the input of the integrated circuit and connected to ground, wherein the second protection stage is arranged for, when triggered, providing a low ohmic path to said ground;
- a triggering mechanism arranged for triggering the second protection stage with the first protection stage.

2. An ESD protection device in accordance with claim 1, wherein said triggering mechanism is arranged for triggering both said first and said second protection stage.

3. An ESD protection device in accordance with claim 1, wherein said triggering mechanism is arranged for triggering said second protection stage when said first protection stage has been triggered.

4. An ESD protection device in accordance with claim 3, wherein said first protection stage is triggered by an input voltage at said external input exceeding a predefined voltage threshold.

5. An ESD protection device in accordance with claim 2, wherein said triggering mechanism is driven by an input voltage at said external input exceeding a predefined voltage threshold.

6. An ESD protection device in accordance with any of the previous claims, wherein the first and second protection stages comprise a snap-back device.

7. An ESD protection device in accordance with any of the previous claims, wherein the first protection stage and/or the second protection stage comprises any of:
- a Transistor;
- a silicon controlled rectifier, SCR.

8. An ESD protection device in accordance with claim 6, wherein the second protection stage comprises the transistor and/or SCR, and wherein the triggering mechanism is arranged to trigger the transistor by controlling the control terminal of the transistor.

9. An ESD protection device in accordance with any of the claims 6 - 7, wherein the transistor and/or SCR is any of:
- A Field Effect Transistor, FET;
- A Bipolar Junction Transistor, BJT;
- a Thyristor.

10. An ESD protection device in accordance with any of the previous claims, wherein the first protection stage and the second protection stage comprise:
- a transistor and/or SCR implemented as a multi finger structure in a semiconductor material, wherein an active finger of said multi finger structure triggers an inactive finger of said multi finger structure.

11. An ESD protection device in accordance with claim 10, wherein said first protection stage comprises a first set of fingers and said second protection stage comprises a second set of fingers and said ground comprises a third set of fingers;
wherein the first set of fingers is interleaved with the third set of fingers and wherein the second set of fingers is interleaved with the third set of fingers.
wherein active fingers of said first or second set of fingers are electrically connected to neighbouring fingers of said third set of fingers;
wherein an active finger of said first set of fingers is arranged to trigger an inactive finger of said second set of fingers.

12. An ESD protection device in accordance with claim 10, wherein said second set of fingers is provided in extension of said first set of fingers;
wherein upon the triggering of an inactive finger of said first set of fingers, said finger of said second set fingers in extension with said triggering finger of said first set fingers is triggered.

13. An assembly of an ESD protection device in accordance with any of the previous claims and an integrated circuit,
wherein the two-stage protection circuit is connected to the input of the integrated circuit,
wherein the impedance is connected to the external input and to the input of the integrated circuit,
wherein the second protection stage is connected to the input of the integrated circuit and connected to ground.

14. An electronic device comprising an assembly in accordance with claim 13.

15. A method of providing ElectroStatic Discharge, ESD, protection by an ESD protection device in accordance with any of the claims 1 - 12, wherein said method comprises the steps of:
- triggering, by said triggering mechanism, said second protection stage with said first protection stage.

16. A method in accordance with claim 15, wherein said step of triggering comprises one of:
- triggering both said first and said second protection stage, or
- triggering said second protection stage when said first protection stage has been triggered.
